# EUROPEAN PATENT APPLICATION

(11) **EP 3 892 585 A1**
(43) Date of publication of application: **13.10.2021**
(21) Application number: 20169036.9
(22) Date of filing: 09.04.2020
(51) Int. Cl.: B82Y 30/00, B82Y 40/00, C23C 16/40, C23C 16/455, H01L 21/02, C23C 16/02

(54) **GROWING A DIELECTRIC MATERIAL ON A SURFACE**

(71) Applicant: Imec VZW, 3001 Leuven (BE)
(72) Inventor: COTT, Daire, 3001 Leuven (BE); SCHAPMANS, Elie, 3001 Leuven (BE)
(74) Representative: DenK iP bv

(57) **Abstract**

The present invention relates to a method for growing a dielectric material on a surface (20), comprising: (a) introducing the surface (20) into a first process chamber (11); (b) in the first process chamber (11), exposing (31) the surface (20) to a first precursor (41) thereby adsorbing the first precursor (41) to the surface (20); (c) without purging the first process chamber (11), introducing (51) the surface (20) into a second process chamber (12); and (d) in the second process chamber (12), exposing (32) the surface (20) to a second precursor (42) thereby reacting the adsorbed first precursor (41) with the second precursor (42) to grow the dielectric material on the surface (20).

## Description

### Technical field of the invention

The present invention relates to growing dielectric materials on surfaces and in particular to methods which allow such growth on inert surfaces.

### Background of the invention

Atomic layer deposition (ALD) is a thin-film deposition technique based on the sequential deposition of two or more gas phase precursors through surface reactions. The surface-to-be-coated is exposed to and reacted with these precursors one at a time in a sequential, self-limiting manner. After each exposure step, the remaining unreacted precursor is then purged from the process chamber before a new exposure step with another precursor is started. Through repeated cycling of the exposure steps, a thin film is gradually grown. ALD is a key process in various manufacturing processes, particularly in the context of semiconductor device fabrication. For example, scaled high-k gate dielectrics are typically grown using ALD.

However, since ALD relies on chemically binding (e.g. through chemisorption) the precursors to the surface, the surface must have a minimum reactivity to commence the process. Indeed, if the first precursor does not react with the surface, it will readily desorb from the surface during the purging step and will thus not be available for reaction with the second precursor during the next exposure step. The purging step can typically not be dispensed with as ALD systems are not designed to have (high) concentrations of precursors remaining in the process chamber and/or gas lines between exposure steps. If the unreacted precursor is insufficiently removed from the ALD system, then the concurrently present precursors can react-in a non-ALD, traditional chemical vapour deposition (CVD) manner-in the gas phase to form unwanted particles of reaction product which then precipitate onto the surface, thereby negatively influencing the quality of the deposited film, and/or form deposits in the gas lines which feed the process chamber, there causing disruption of the ALD system.

ALD on two-dimensional (2D) materials-such as graphene, hexagonal boron nitride (h-BN) or a transition metal dichalcogenide (TMD or TMDC) monolayers-would be a convenient way to form dielectric layers onto the 2D materials; for example, in the manufacture of nanoelectronic devices. However, an ideal 2D material surface typically has little or no reactive sites for chemical bond formation and is therefore inert. Reaction of the precursor with a real, pristine 2D material is therefore typically restricted to grain boundaries and local defects thereof, so that the number of nucleation sites for further growth is limited. As such, good ALD-like deposition on such surfaces is generally extremely challenging and thick layers need to be deposited before a uniform film can be achieved.

Different strategies have been proposed to alleviate this shortcoming, however each come with their own drawbacks. US20180158670A1 describes a method for forming an ALD oxide layer on a clean inert surface, comprising first forming a nanofog of Al₂O₃ nanoparticles of limited dimensions (0.5-2 nm) via a CVD growth component in the gas phase, then adhering the Al₂O₃ nanoparticles to the surface and next forming an Al₂O₃ layer via ALD that is nucleated via the Al₂O₃ nanoparticles. However, the nanoparticles formed in the gas phase will have different characteristics compared to a corresponding material grown by ALD. For example, whereas an ALD-grown dielectric material will typically be characterized by a generally conformal geometry with respect to the surface it is grown on, nanoparticles formed in the gas phase will typically adopt a more spherical geometry. Moreover, each sequential reaction step in ALD is self-limiting, but this is not for CVD growth where all precursors are simultaneously present in the gas phase. This difference will influence the exact nature of the material that is formed. As such,-even if the nanoparticle dimensions are kept limited-the combination of CVD and ALD growth modes will typically lead to inferior characteristics compared to a corresponding fully-ALD grown layer.

Another approach is described in US9028919B2, where epitaxially grown graphene (EG) sample is first functionalized ex situ using either a wet or dry chemistry conditioning, followed by ALD deposition of a dielectric on the functionalized surface. In the wet chemistry conditioning, any oxides and/or impurities are first removed from the EG sample, after which it is placed in a warm NH₄OH:H₂O₂:DI solution for several minutes to promote the formation of an OH-terminated surface. The dry chemistry conditioning, the EG sample is exposed to an active gas (e.g. XeF₂) to create C-F bonds on the surface of the EG sample. In both cases, the OH- or F-functionalization are considered necessary to allow initial nucleation in the ALD process. However, the very act of chemically functionalizing a 2D material such as graphene changes its electronic properties-among others-and may for example drastically impact its conductivity by breaking up its conjugated system.

There is thus still a need in the art for better methods to grow dielectric materials on surfaces, including inert surfaces, which address at least some of the issues outlined above.

### Summary of the invention

It is an object of the present invention to provide good ways for growing a dielectric material on a surface. This objective is accomplished by methods according to the present invention.

It is an advantage of embodiments of the present invention that dielectric materials can be grown even on inert and/or hydrophobic surfaces.

It is an advantage of embodiments of the present invention that a first precursor can be kept adsorbed to the surface, even where there is no chemical binding therebetween. It is a further advantage of embodiments of the present invention that both mechanical desorption (e.g. due to purging) and thermal desorption (e.g. due to the surface temperature) can be reduced or avoided.

It is an advantage of embodiments of the present invention that the dielectric material can be grown in a sequential, self-limiting manner; substantially in absence of a CVD growth component (e.g. reactions in the gas phase are minimized).

It is an advantage of embodiments of the present invention that reactions between the precursors and subsequent deposits in the gas lines are prevented.

It is an advantage of embodiments of the present invention that the surface on which the dielectric material is grown can belong to a variety of substrates, including 0D, 1D, 2D and 3D materials.

It is an advantage of embodiments of the present invention that a variety of dielectric materials can be grown.

It is an advantage of embodiments of the present invention that the surface can be prepared for a further ALD process.

It is an advantage of embodiments of the present invention that the method can be performed in a relatively straightforward and economical fashion.

It is an advantage of embodiments of the present invention that a good surface coverage can be achieved (e.g. substantially covering the entire surface). It is a further advantage of embodiments of the present invention that such a good surface coverage can be achieved within a limited thickness of dielectric material (e.g. within 10 nm).

As mentioned in the background and as further illustrated herein (cf. Example), ALD on surfaces without sufficient chemical reactivity-which is for example typically the case for 2D materials-is non-trivial, because any first precursor that is not chemically bound but only physically adsorbed ('physisorbed') during the corresponding exposure step, readily desorbs during the subsequent purging step of the ALD process and is thus removed before it can be reacted with a second precursor in the next exposure step. On such surfaces, deposition by ALD can thus only start at and grow out from reactive sites-such as grain boundaries and local defects-where chemical binding of the first precursor is possible. In subsequent cycles, the previously bound precursors and/or formed dielectric material can then act as a nucleation site for further growth, though the problem of the unreactive surface itself will persist. As such, with increasing cycles, the growth of the dielectric material is dominated by expansion-both parallel and perpendicular to the surface-out from these reactive sites. However, when the number of such reactive sites is low and they are spread thin, an exceedingly large number of ALD cycles is needed to bridge the gaps therebetween before achieving full surface coverage. Since the dielectric also grows out perpendicular to the surface during this process, the resulting dielectric film is at that point already relatively thick (e.g. in the order of several tens of nanometer). This thus precludes the formation of relatively thin dielectric layer on pristine low- or unreactive materials by ALD, as would for example be desired in the formation of advanced semiconductor devices.

As also previously described, simply dispensing with the purging step is incompatible with the ALD systems and process, leading to unwanted deposition in the gas lines and CVD reaction products which compromise the deposited dielectric film quality.

However, it was surprisingly found within the present invention that the dielectric material can be grown directly on the pristine surface-even where no reactive sites are present-by adsorbing the first precursor thereto in a first deposition chamber and then-without purging-moving the substrate to a different second process chamber, where the adsorbed first precursor is reacted with a second precursor. Analogous to traditional ALD cycles, this cycle of steps can optionally be repeated. This not only further expands the previously formed dielectric material but also produces new nucleation sites. Once a suitable density of such nucleation sites is reached, there is then the option to stop moving the substrate between process chambers (e.g. keeping it in the second process chamber) and instead use the already formed dielectric material as a nucleation layer for a traditional ALD process. In that sense, the present invention can thus be used to prepare a (pristine) surface for ALD.

The present invention thus relates to a method for growing a dielectric material on a surface, comprising: (a) introducing the surface into a first deposition chamber; (b) in the first process chamber, exposing the surface to a first precursor thereby adsorbing the first precursor to the surface; (c) without purging the first process chamber, introducing the surface into a second process chamber; and (d) in the second process chamber, exposing the surface to a second precursor thereby reacting the adsorbed first precursor with the second precursor to grow the dielectric material on the surface.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG 1 schematically depicts a method in accordance with embodiments of the present invention.
FIG 2 to FIG 16 show scanning electron microscopy (SEM) images of Al₂O₃ deposited on different WS₂ surfaces.
FIG 17 shows a plot of achieved surface coverage in function of ALD layer thickness Al₂O₃ for Al₂O₃ deposited on different WS₂ surfaces.
FIG 18 to FIG 20 show atomic force microscopy (AFM) images of Al₂O₃ deposited on different WS₂ surfaces.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms on, under, above, below and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms are provided solely to aid in the understanding of the invention.

As used herein, and unless otherwise specified, a 2D (two-dimensional) material is a crystalline material consisting of a single monolayer of covalently bonded atoms or consisting of a few (e.g. two or three) such monolayers held together by van der Waals forces. The covalently bonded atoms may be coplanar-as is for example the case in graphene-or they may span a few levels-as is for example the case for transition metal dichalcogenides (TMD or TMDC), where the transition metal atoms form one (coplanar) level and are covalently bound to dichalcogenides on a level thereabove and therebelow. Regardless, the monolayers in a 2D material are typically considered to be atomically thin, i.e. they are one or a few atoms thick. Self-assembled monolayers (SAMs) are not 2D materials in the sense of the present invention since they are not crystalline and the molecules which make them up are typically not covalently bound to one another. Moreover, they are not atomically thin but have a thickness corresponding to the height of the self-assembling molecule. In preferred embodiments, the 2D material may consist of a single monolayer. Nevertheless, perfect control over the growth of 2D materials is typically not trivial and local instances may occur where a few monolayers are stacked.

As used herein, and unless otherwise specified, (traditional) chemical vapour deposition (CVD) refers to a deposition technique (e.g. for thin-film deposition) in which a substrate is simultaneously exposed to two or more gas phase precursors. The gas phase precursors react in the gas phase or on the substrate to form the desired deposition material. Thus, although CVD could be defined-and occasionally is in the art-so as to encompass ALD as a particular subtype thereof, these are herein considered to be distinct, separate techniques.

As used herein, and unless otherwise specified, (traditional) atomic layer deposition (ALD) refers to a deposition technique (e.g. for thin-film deposition) in which a substrate is sequentially exposed to two or more gas phase precursors. Each gas phase precursor reacts with the substrate in a self-limiting manner, after which any remaining unreacted precursor is purged from the process chamber before starting a new exposure step with another precursor. A cycle of these different exposure and intermediate purging steps is then typically repeated to grow a film of a desired thickness. Thus, although ALD could be defined so as to encompass the cycle of steps a to d-or e, if present-of the present invention as a particular subtype thereof, these are herein considered to be distinct, separate techniques. In particular, while step d-and, if present, e-herein may be analogous to the steps used in traditional ALD, steps a to c typically differ therefrom.

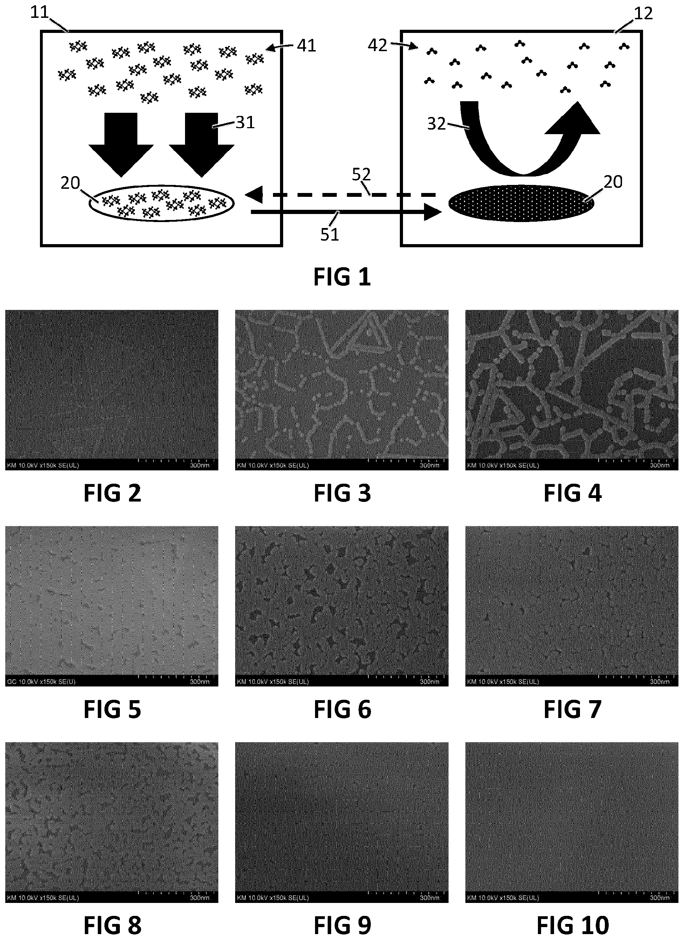

The present invention relates to a method for growing a dielectric material on a surface, comprising: (a) introducing the surface into a first deposition chamber; (b) in the first process chamber, exposing the surface to a first precursor thereby adsorbing the first precursor to the surface; (c) without purging the first process chamber, introducing the surface into a second process chamber; and (d) in the second process chamber, exposing the surface to a second precursor thereby reacting the adsorbed first precursor with the second precursor to grow the dielectric material on the surface. This is schematically depicted in FIG 1, showing a first process chamber (11) in which the surface (20) is exposed (31) to a first precursor (41), thereby adsorbing the first precursor (41) to the surface (20), and a second process chamber (12) in which the surface (20) is exposed (32) to a second precursor (42), thereby reacting the first precursor (41) with the second precursor (42) and forming the dielectric material on the surface (20). Herein, the first process chamber (11) is not purged before moving (51) the surface (20) to the second process chamber (12).

Within the present invention, the first process chamber is thus distinct from the second process chamber; i.e. a single process chamber cannot be both the first and second process chamber. In embodiments, the first and/or second may be a first and/or second deposition chamber, respectively.

In embodiments, the surface may be an inert surface (i.e. unreactive towards chemical functionalization). In embodiments, the surface may be inert with respect to the first precursor (i.e. unreactive towards chemical functionalization with the first precursor). In embodiments, at most 10% of sites of the surface may be reactive, preferably at most 3%, more preferably at most 1%, yet more preferably at most 0.3%, most preferably at most 0.1%, such as at most 0.03%. The existence of reactive sites may be reflected in a change in stoichiometry away from the ideal stoichiometric ratio (i.e. the stoichiometric ratio of the corresponding material without surface defects or grain boundaries). For example, a change in the S:W ratio for WS₂ away from 2:1 typically indicates dangling bonds will be present, which tend to be reactive towards chemical functionalization. In embodiments, the surface may be stoichiometric; i.e. a stoichiometric ratio of the surface may differ from the ideal stoichiometric ratio by at most 10%, preferably at most 3%, more preferably at most 1%, yet more preferably at most 0.3%, most preferably at most 0.1%, such as at most 0.03%. The amount (e.g. the total length) of grain boundaries, which are also typically more reactive, is generally a function of the average grain size; where a smaller average grain size corresponds to more grain boundaries. In embodiments, the average grain size of the surface may be 50 nm or more, preferably 75 nm or more, more preferably 100 nm or more, yet more preferably 150 nm or more, most preferably 200 nm or more. In preferred embodiments, the surface may be stoichiometric and the average grain size of the surface may be 50 nm or more, preferably 75 nm or more, more preferably 100 nm or more, yet more preferably 150 nm or more, most preferably 200 nm or more

In embodiments, the surface may be a hydrophobic surface. Here, the hydrophobicity of the surface may be determined through measurement of the static water contact angle of the surface, wherein the surface is considered hydrophilic if the static water contact angle is smaller than 75° and hydrophobic if the static water contact angle is larger than or equal to 75°. Static contact angle measurements are well known to the person of ordinary skill in the art and can for example be performed using a commercially available contact angle goniometer. Inert surfaces typically also tend to be hydrophobic, so that these classes may significantly overlap.

Although the present invention can in principle be used on any kind of surface (i.e. both inert or reactive and hydrophobic or hydrophilic), it is particularly advantageous for surfaces with respect to which it is difficult to chemically bind the first precursor, where traditional ALD is ill-suited (cf. supra and infra).

In embodiments, the surface may be a surface of a substrate. In embodiments, step a and c may thus respectively comprise introducing a substrate comprising the surface into the first and second deposition chamber. In embodiments, the substrate may be a 0D (e.g. a nanoparticle), 1D (e.g. a nanotube or nanowire), 2D or 3D material. In preferred embodiments, the surface may be the surface of the 2D material. The provision of a (thin) dielectric film on 2D materials is particularly desired in the context of advanced semiconductor device fabrication, but this was hereto challenging due to the typical inertness of these materials. The present invention in thus particularly advantageous in combination with such materials. In embodiments, the 2D material may be graphene, hexagonal boron nitride or a transition metal dichalcogenide. In embodiments, the substrate (e.g. the 0D, 1D, 2D or 3D material) may be provided on a carrier (i.e. a further substrate). For example, the 2D material may be present on a wafer and introduced as such into the first deposition chamber and/or second process chamber.

In embodiments, the first precursor may be a compound of Al, Ti, Hf or Zr. In embodiments, the compound may be a metal halide or organometallic compound. The halide compound may for example be a chloride compound, such as TiCl₄, HfCl₄ or ZrCl₄. The organometallic compound may for example be an alkyl compound-such as an alkylaluminium (e.g. trimethylaluminium, TMA)-or an alkylamido compound-such as an alkylamidotitanium (e.g. tetrakis(dimethylamido)titanium(IV) or tetrakis(diethyl-amido)titanium(IV)), an alkylamidohafnium (e.g. tetrakis(dimethylamido)hafnium(IV) or tetrakis(diethylamido)hafnium(IV)), or an alkylamidozirconium (e.g. tetrakis(dimethyl-amido)zirconium(IV) or tetrakis(diethylamido)zirconium(IV)). In preferred embodiments, the first precursor may be trimethylaluminium (TMA) or TiCl₄. Both TMA and TiCl₄ advantageously have a relatively high vapour pressure, such that a considerable partial pressure (e.g. from 1 to 50 Torr, preferably from 5 to 40 Torr, yet more preferably from 10 to 30 Torr) thereof can be achieved at relatively low temperatures (e.g. from e.g. from 0 to 80 °C, preferably from 10 to 60 °C, yet more preferably from 20 to 40 °C). As such,-despite the inevitable pressure drop between the first precursor source and the first process chamber-these high vapour pressure first precursors can advantageously be vapour drawn into the first process chamber without the need for a carrier gas.

In embodiments, step b may comprise exposing the surface to a gas of the first precursor for at least 1 min, preferably at least 2 min, more preferably at least 5 min, such as 10 min. Step b may typically be performed for a duration longer (e.g. by a factor of about 10 to 250 times) than an ordinary ALD exposure step, which is typically between about 250 ms and 10 s long; thereby advantageously promoting adsorption of the first precursor onto the surface.

In some embodiments, the first precursor may be vapour drawn into the first process chamber without a carrier gas. Vapour drawing the first precursor into the first process chamber without a carrier gas advantageously allows to expose the surface only to the (pure) first precursor, thereby minimizing any other species (e.g. the carrier gas) that could interfere with the adsorption of the first precursor. In other embodiments, the first precursor may be brought into the first process chamber using a carrier gas. In some instances, the vapour pressure of the first precursor at a suitable operating temperature (e.g. sufficiently lower than a decomposition temperature thereof) may be too low to efficiently draw them into the first process chamber as such. Such first precursors may nevertheless still be used by combining them with a carrier gas to bring them into the first process chamber. The carrier gas may preferably be an inert gas, such as a noble gas (e.g. Ar) or N₂.

In embodiments, a partial pressure of the first precursor in the first process chamber may in step b be from 0.1 to 30 Torr, preferably from 1 to 20 Torr, yet more preferably from 5 to 10 Torr. The partial pressure may thus be larger (e.g. by a factor of about 2 to 10) than generally used in ALD, which is typically about 1 to 3 Torr; thereby advantageously promoting adsorption of the first precursor onto the surface.

In embodiments, the surface (e.g. the substrate) may in step b have a temperature of 200 °C or less, preferably 150 °C or less, more preferably 100 °C or less, yet more preferably 80 °C or less, most preferably 60 °C or less, such as between 20 and 40 °C. Exposure to the first precursor can advantageously be performed at a relatively low temperature compared to traditional ALD, where temperatures of 300 °C or more are commonly employed. This has a positive effect on the amount of first precursor that is adsorbed on the surface, since this amount is typically inversely related to the temperature of the surface (i.e. more adsorption/less desorption is typically achieved at lower temperatures).

By not purging the first process chamber after step b, but instead directly introducing the substrate into a second process chamber in step c, the large-scale desorption-as occurs in traditional ALD-of unreacted (i.e. not chemically bound), physisorbed first precursor is advantageously avoided.

The second precursor may typically be a reagent which reacts with the first precursor to yield the desired dielectric material. In embodiments, the second precursor may be an oxidant selected from H₂O, O₂ and O₃. In embodiments, the parameters (e.g. pressure, time, and temperature) used in step d for exposing the surface to the second precursor-thereby reacting the adsorbed first precursor with the second precursor-may be analogous to those used for a second precursor exposure step in ALD. For example, a normal ALD exposure step (e.g. of H₂O as second precursor) may typically last between about 250 ms and 10 s (e.g. between 1 to 10 s), at a partial pressure of about 1 to 3 Torr in the process chamber and a substrate temperature of about 300 °C or more.

In embodiments, the dielectric material may be selected from an aluminium oxide(e.g. Al₂O₃), a titanium oxide (e.g. TiO₂), a hafnium oxide (e.g. HfO₂) or a zirconium oxide (e.g. ZrO₂).

In preferred embodiments, the method may comprise a further step e, after step d, of: (e) purging the second process chamber. This is schematically depicted in FIG 1 by the curved arrow for the exposure (32) in the second process chamber (12). By purging the second process chamber, any unreacted precursor can advantageously be removed therefrom. At this point, the first precursor has reacted with the second precursor to form a dielectric material. This resulting dielectric material is not as prone to desorption as the first precursor, so that any unreacted precursors can now typically be purged without substantially removing the dielectric material. The purging may for example be performed using an inert gas, such as a noble gas (e.g. Ar) or N₂.

In embodiments, a cycle of steps a to d-or e, if present-may be repeated. This is schematically depicted in FIG 1 by the dashed arrow (52) pointing back towards the first process chamber (11). In embodiments, repeating the cycle may thus comprise introducing the surface back into a first deposition chamber and then repeating steps a to d-and optionally e. Although the present cycle of steps a to d-or e, if present-is distinct from an ALD cycle (cf. supra), it can nevertheless advantageously be repeated like an ALD cycle. In embodiments, the cycle may be repeated from 1 to 999 times, preferably from 1 to 299 times, more preferably from 1 to 99 times, yet more preferably from 1 to 29 times, still yet more preferably from 1 to 9 times, most preferably from 2 to 4 times. Note that this refer to the number of repetitions after the first cycle, so repeating the cycle 2 times corresponds to a total of 3 cycles, repeating 4 times to a total of 5 cycles, etc.

While it is possible to repeat this cycle until a dielectric material of a desired thickness is achieved, one can also use the above steps as a surface preparation method for preparing a (pristine) surface for an ALD process. To this end, one can continue these steps until sufficient nucleation sites have been formed across the surface; depending e.g. on the exposure parameters used and the amount or density of nucleation sites that is desired, this may be after one cycle or may require a plurality of cycles (e.g. to a thickness in the order of 1 nm, e.g. 1 to 2 nm). The so deposited dielectric material can then be used as nucleation layer in a traditional ALD process. In embodiments, the method may thus comprise a further step f, after step d (e.g. after step e, if present), of: (f) performing atomic layer deposition onto the dielectric material grown in step d. This procedure can be advantageous because-once a suitable nucleation layer has been formed-one can omit having to transfer the surface between process chambers and instead simply perform a well-controllable ALD process in a single process chamber (e.g. in the second process chamber) to achieve a high-quality dielectric film. Note that the atomic layer deposition can be used to deposit the same dielectric material (e.g. to further grow the dielectric material), but may also be used to deposit a different material thereon. For example, in some instances it may be beneficial to form an initial nucleation layer of a first dielectric material (e.g. Al₂0₃) and then use this layer to deposit a further dielectric material (e.g. a high-k dielectric, such as HfO₂) by ALD.

In embodiments, the dielectric material may have a surface coverage of at least 80%, preferably at least 90%, more preferably at least 95%, yet preferably at least 99%, such as 100%. In embodiments, the dielectric material may have a thickness of 20 nm or less, preferably 15 nm or less, more preferably 10 nm or less, yet more preferably 7 nm or less, most preferably 5 nm or less, such as 1-2 nm. In preferred embodiments, the dielectric material may simultaneously have the aforementioned surface coverage and the aforementioned thickness.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example: Atomic layer deposition of a dielectric on a 2D material

The deposition of Al₂O₃ by ALD-using trimethylaluminum (TMA) and water as precursors-on the surface of a WS₂ transition metal dichalcogenide was investigated.

FIG 2 to FIG 16 show scanning electron microscopy (SEM) images of the Al₂O₃ deposited on different WS₂ surfaces. Every row of these images forms a set in which the WS₂ surface was prepared in the same way but differ from one another by the number of ALD cycles that have been performed; from left to right: 50, 100 and 150 ALD cycles, respectively.

FIG 2, FIG 3 and FIG 4 show comparative results in which deposition was performed on a pristine WS₂ surface, i.e. without using a surface preparation method in accordance with the present invention. As can be seen, the surface coverage after 50 cycles (FIG 2) is still extremely poor and moreover increases only slowly when increasing to 100 cycles (FIG 3) and 150 cycles (FIG 4). Moreover, it can be observed that Al₂O₃ growth starts out from grain boundaries and local defects of the WS₂ surface and that these features broaden (but also heighten) slowly with increasing number of ALD cycles. In order to then uniformly cover the entire surface, about 500 to 600 cycles are needed (not depicted); i.e. an Al₂O₃ film with a uniform coverage is only achieved from thicknesses of about 50 to 60 nm onwards.

FIG 5 to FIG 16 show results in which the WS₂ surface was prepared in accordance with the present invention by cyclically first adsorbing TMA to the surface in a first process chamber and-without intermediate purging-reacting the adsorbed TMA with water in a different second process chamber, thereby building up an initial nucleation layer for the subsequent ALD cycles (e.g. performed in the second process chamber). The table below shows for each of the sets: the number of preparation cycles applied and the duration, TMA pressure in the first process chamber and substrate temperature used in each TMA adsorbing step. The TMA (partial) pressure was equal to the total pressure in the first process chamber, since TMA was the only gas therein. Note however that there is typically a pressure drop between the TMA source vessel and first process chamber. In order to realize a TMA pressure of 7 Torr or 10 Torr in the first process chamber, a higher vapour pressure of respectively 10 Torr or 27 Torr was therefore generated in the TMA source vessel; corresponding respectively to heating the TMA in the source vessel to 20 °C or 40 °C.

| | Number of cycles | Duration of TMA adsorption (min) | TMA pressure (Torr) | Substrate temperature (°C) |
|---|---|---|---|---|
| FIG 5-FIG 7 | 5 | 5 | 7 | 100 |
| FIG 8-FIG 10 | 5 | 10 | 7 | 100 |
| FIG 11-FIG 13 | 5 | 10 | 10 | 100 |
| FIG 14-FIG 16 | 3 | 5 | 10 | 100 |

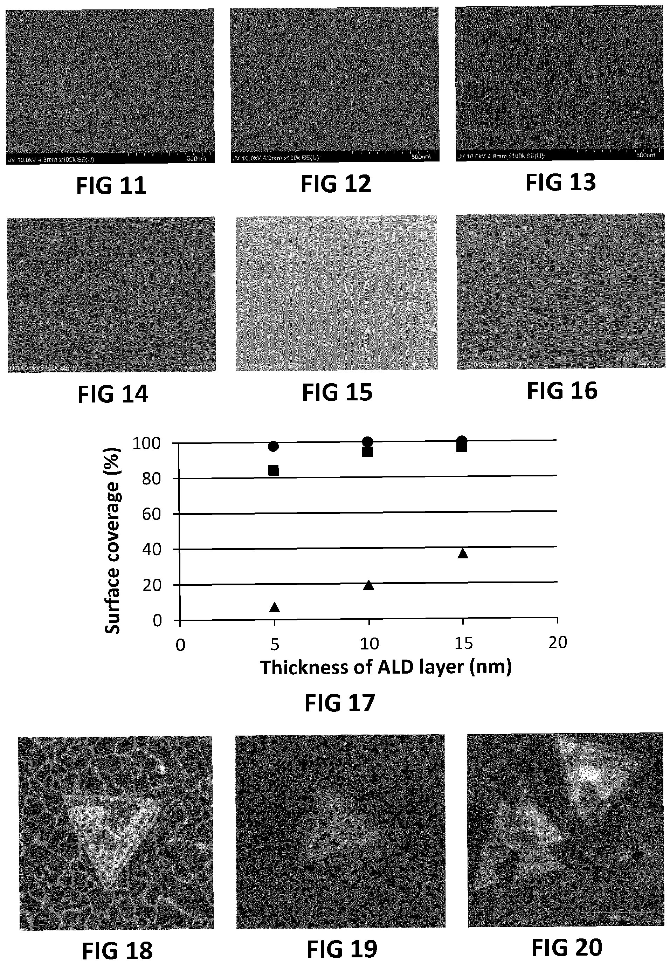

In contrast to FIG 2-FIG 4, it is clearly seen in FIG 5-FIG 16 that-by preparing the WS₂ surface using an ALD-like (i.e. without CVD growth component) process, but wherein flush step afterTMA exposure is replaced by moving the substrate to a different process chamber, a markedly improved surface coverage is achieved because the TMA that remains adsorbed and then subsequently reacts with water, thereby forming initial nucleation sites not only at the grain boundaries but across the whole WS₂ surface. Thanks to these more uniformly distributed nucleation sites, the subsequent ALD growth happens more evenly across the surface and layer closure is achieved more quickly. Depending on the parameters used during surface preparation, and thus the characteristics (e.g. number and/or density) of the nucleation sites formed, an ALD film with full surface coverage can already be achieved from 150 (e.g. FIG 10), 100 (e.g. FIG 15) or even 50 (e.g. FIG 20, cf. infra) cycles onwards.

The above effect is also seen in FIG 17, where the achieved surface coverage is plotted in function of the Al₂O₃ ALD layer thickness (where 5, 10 and 15 nm corresponds to respectively 50, 100 and 150 ALD cycles) for deposition on a pristine WS₂ surface (triangles), a WS₂ surface prepared using a single preparation cycle with a 5 min TMA adsorption step at 7 Torr and 100 °C substrate temperature (squares) and a WS₂ surface prepared using three preparation cycles with a 5 min TMA adsorption step at 10 Torr and 100 °C substrate temperature in each (circles; cf. FIG 16).

FIG 18 to FIG 20 show atomic force microscopy (AFM) images of a 5 nm Al₂O₃ layer deposited by ALD on a pristine WS₂ surface (FIG 18) and two WS₂ surface prepared in accordance with the present invention (FIG 19 and FIG 20). These again show that ALD growth is directed by grain boundaries and local defects in the case of a pristine 2D surface, leading to poor surface coverage for thin ALD layers; whereas a much better surface coverage is achieved if the surface had been prepared in accordance with the present invention, in which case even full surface coverage can be achieved after only 50 cycles ALD cycles (i.e. a layer thickness of 5 nm).

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for growing a dielectric material on a surface (20), comprising:
a. introducing the surface (20) into a first process chamber (11);
b. in the first process chamber (11), exposing (31) the surface (20) to a first precursor (41) thereby adsorbing the first precursor (41) to the surface (20);
c. without purging the first process chamber (11), introducing (51) the surface (20) into a second process chamber (12); and
d. in the second process chamber (12), exposing (32) the surface (20) to a second precursor (42) thereby reacting the adsorbed first precursor (41) with the second precursor (42) to grow the dielectric material on the surface (20).

2. The method according to claim 1, wherein the surface (20) is an inert surface.

3. The method according to any of the previous claims, wherein the surface (20) is a surface of a 2D material.

4. The method according to claim 3, wherein the 2D material is graphene, hexagonal boron nitride or a transition metal dichalcogenide.

5. The method according to any of the previous claims, wherein step b comprises exposing (31) the surface (20) to a gas of the first precursor (41) for at least 1 min, preferably at least 2 min, more preferably at least 5 min.

6. The method according to any of the previous claims, wherein in step b a partial pressure of the first precursor in the first process chamber is from 0.1 to 30 Torr, preferably from 1 to 20 Torr, yet more preferably from 5 to 10 Torr.

7. The method according to any of the previous claims, wherein in step b the surface (20) has a temperature of 200 °C or less, preferably 150 °C or less, more preferably 100 °C or less, yet more preferably 80 °C or less, most preferably 60 °C or less.

8. The method according to any of the previous claims, comprising a further step e, after step d, of:
e. purging the second process chamber (12).

9. The method according to any of the previous claims, wherein a cycle of steps a to d-or, if present, e-is repeated (52) from 1 to 9 times, preferably from 2 to 4 times.

10. The method according to any of the previous claims, comprising a further step f, after step d, of:
f. performing atomic layer deposition onto the dielectric material grown in step d.

11. The method according to any of the previous claims, wherein the first precursor (41) is vapour drawn into the first process chamber (11) without a carrier gas.

12. The method according to any of claims 1 to 10, wherein the first precursor (41) is brought into the first process chamber (11) using a carrier gas.

13. The method according to any of the previous claims, wherein the first precursor (41) is a compound of Al, Ti, Hf or Zr.

14. The method according to claim 13, wherein the first precursor (41) is trimethylaluminum or TiCl₄.

15. The method according to any of the previous claims, wherein the second precursor (42) is an oxidant selected from H₂O, O₂ and O₃.
